Europäisches Patentamt

European Patent Office

Office européen des brevets

(11) Publication number: **0 316 039**
**A2**

## (12) EUROPEAN PATENT APPLICATION

(21) Application number: 88202472.2

(22) Date of filing: 04.11.88

(51) Int. Cl.⁴: **B23C 3/28**

(30) Priority: 09.11.87 IT 2256787

(43) Date of publication of application:
17.05.89 Bulletin 89/20

(84) Designated Contracting States:
AT BE CH DE ES FR GB IT LI

(71) Applicant: TELMEC S.P.A.
Via 1o Maggio 31
Trezzano Rosa (Milan)(IT)

(72) Inventor: Sala, Sergio
Via Carcassola 64
Trezzo D'Adda (Milan)(IT)

(74) Representative: Raimondi, Alfredo, Dott. Ing.
Prof. et al
Studio Tecnico Consulenza Brevetti Piazzale
Cadorna 15
I-20123 Milano(IT)

(54) **Machine for machining close parallel score lines on plane sheets.**

(57) The machine for machining close parallel scores lines on plane sheets of the invention comprises a horizontal member for conveying the sheets being processed between a loading area and an unloading area for these sheets and several adjacent groups of milling cutters disposed in succession in the feed direction of the sheet, each bearing an independent milling unit which can be located in the direction travsverse to the feed direction of the sheet, means being provided for adjusting the position of each milling unit in the transverse direction and its machining depth.

Fig. 1

# MACHINE FOR MACHINING CLOSE PARALLEL SCORE LINES ON PLANE SHEETS

The present invention relates to a machine for machining close parallel score lines on plane sheets.

For some types of production, in particular the production of printed circuits for electronic apparatus it is necessary to provide single plane elements from sheets or the like of larger size forming several adjacent plane elements, separating the individual elements, when processing is complete, by parallel and intersecting incisions or cuts which bound the required unit sections.

In particular, in the case of printed circuits, several single circuits are printed on a single support board, using known techniques, so as to achieve high productivity levels and ease of handling, and the single units are separated thereafter by providing two series of parallel right-angled incisions on the upper and lower surfaces of the board, making it possible to break the board up by bending it along the lines provided.

Machines for this purpose are known and comprise several milling cutters mounted on the same shaft at the distances required for the incisions; however, these machines have operating limits since the distance between two adjacent incisions cannot with these machines be reduced below a certain value corresponding to the dimensions of the mounting and support members of each individual tool on the shaft, while the most recent technological developments require the use of printed circuits with ever decreasing dimensions.

This raises the problem of providing a machine which makes it possible to overcome these drawbacks and to carry out the machining of incisions at any distance without limits.

These results are achieved by the present invention, which provides a machine for machining close parallel score lines on plane sheets, characterized in that it comprises a horizontal member for conveying the sheets being processed between a loading area and an unloading area for these sheets and several adjacent groups of milling cutters disposed in succession in the feed direction of the sheet, each bearing an independent milling unit which can be located in the direction transverse to the feed direction of the sheet, means being provided for adjusting the position of each milling unit in the transverse direction and its machining depth.

Each milling group comprises an upper crossbar and a lower crossbar connected slidably in the vertical direction between two pairs of vertical columns rigid with the frame of the machine, respectively bearing an upper carriage and a lower carriage which can slide horizontally along the crossbars, each carriage being provided with a milling tool with a respective motor drive member facing the corresponding tool on the opposite carriage at the level of passage of the sheets being conveyed by the conveyor, further support and guide rollers for the sheets being provided on the carriages.

The lower carriage is provided with screw means for regulating its position along the crossbar and means for connection to the upper carriage.

The screw means for adjusting the position of the lower carriage are formed by a screw borne by the lower crossbar and connected axially thereto engaged in a nut connected rigidly to the lower carriage.

The means for connecting the lower carriage to the upper carriage are formed by a wedge-shaped tapered bolt borne by one of the carriages which can be moved towards the opposite carriage by means of an associated actuator, in correspondence with which there is provided on the opposite carriage a recessed block designed to receive the bolt when it is in the extended position, thus coupling the carriages in translation.

In an embodiment of the invention, for each pair of facing upper and lower carriages, at least one of the support and guide rollers for the sheets is motor driven in order to entrain the sheets.

In this case the motor-driven support roller is actuated at a speed which is slightly higher than that of the sheet conveyor member and the conveyor member is connected to the relative motor means via a free wheel designed to allow the sheets to be entrained by the support and guide rollers when they are in engagement therewith.

As an alternative, if the entrainment of the conveyor group is sufficient, the support and guide rollers for the upper and lower carriages are idle and the entrainment of the sheets is carried out solely by the conveyor member.

The means for adjusting the depth of machining are formed, for each of the upper crossbars, by a pair of brackets projecting at the ends of the crossbars and provided with associated inclined slides bearing on corresponding wedge-shaped means which can slide longitudinally on guides rigid with the columns sliding longitudinally with fine adjustment of position, thereby determining the height of the crossbar bearing thereon.

The lower crossbars of each milling group are provided with cam means for raising and lowering them between a working position with the tool borne by the associated carriage at the height provided for working on the sheet and a lowered position allowing access to and maintenance of the tools.

Further details are given in the following description, made with reference to the attached drawings, in which:

Fig. 1 is an overall side view of the machine of the invention, partly in section;

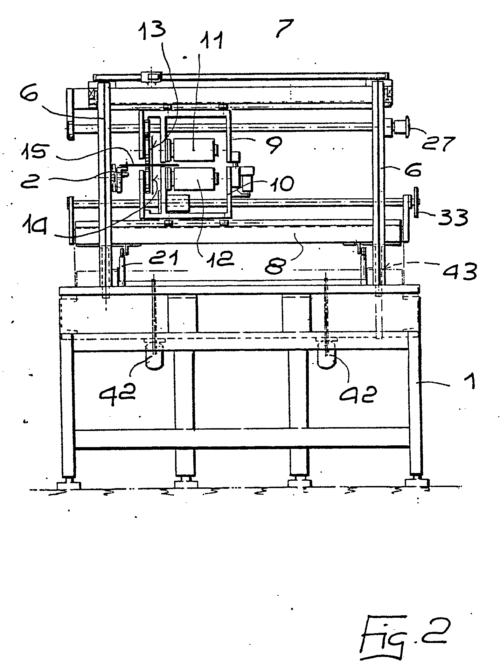

Fig. 2 is a front view of the machine of Fig. 1;

Fig. 3 is a plan view of the machine of Fig. 1, in cross-section along the line III-III;

Fig.4 is a cross-section along the line IV-IV of Fig. 3 on an enlarged scale;

Fig. 5 is a cross-section along the line V-V of Fig. 1, showing a detail of the machine;

Fig. 6 is a side view of the detail of Fig. 5.

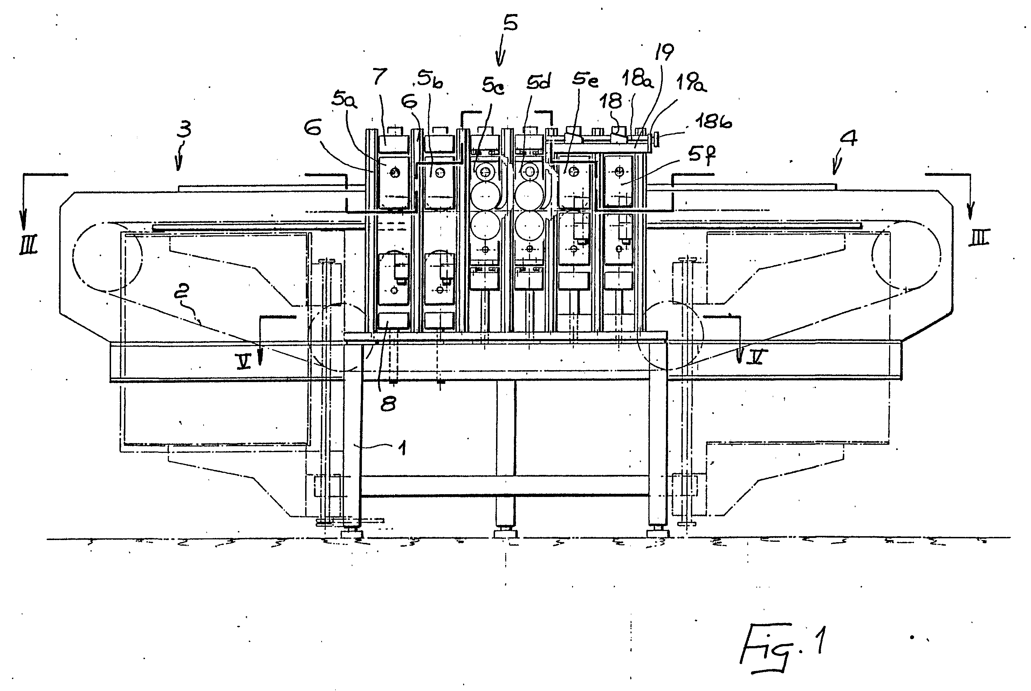

As shown in Fig. 1, the machine of the invention comprises a frame 1 bearing a conveyor member 2 for the circuits being processed connecting a loading area 3 and an unloading area 4 for the circuits.

In these areas the loading of the circuits on the conveyor member may be carried out manually or by means of automatic loading and unloading devices.

The conveyor member 2 passes through a milling group 5 comprising a plurality of milling units 5a, 5b, 5c, 5d, 5e, 5f, whose number corresponds to the number of incisions to be made on the surface of the circuits, aligned in sequence.

Each milling unit 5 is formed by four columns 6 connected to the frame 1 on which the respective upper and lower crossbars 7, 8 can move vertically in translation, which crossbars support, such that they can move horizontally in translation, the carriages 9, 10 connected respectively to the lower and upper crossbars and bearing the motors 11, 12 whose shafts have keyed on them the rotary milling cutters 13, 14 disposed above and below the circuit to be scored 15 which is conveyed through them by the conveyor member 2.

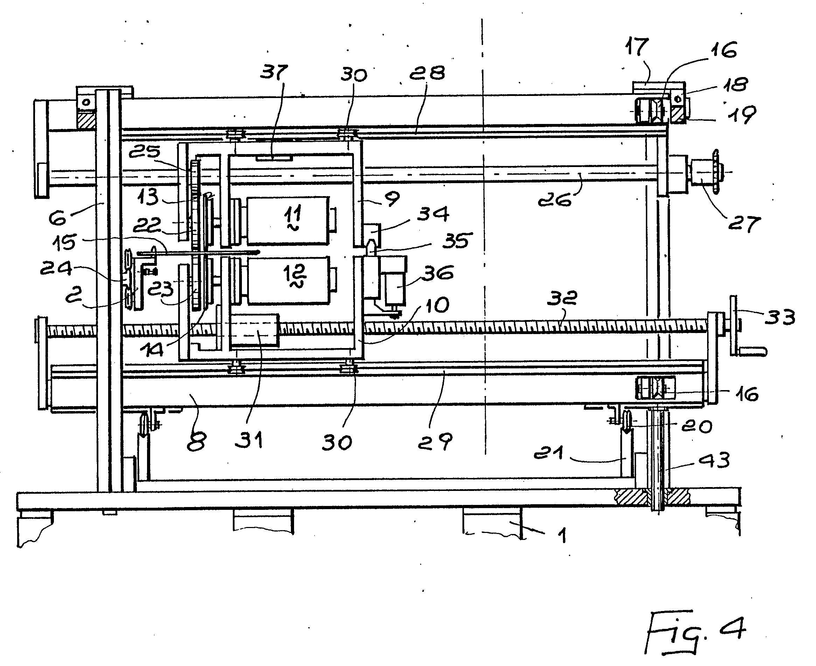

In greater detail, as shown in Fig. 4, the columns 6 from the runway track for the wheels 16 of the crossbar 7, 8; the upper crossbar 7 is connected and held in position at the desired height by respective brackets 17 bearing on wedges 18 which in turn slide on the associated guide 19; all the wedges 18 of each side are connected together by a rod 18a whose end is threaded and inserted in a nut 19a borne by the columns 6 at one end of the guide 19 and can be rotated for the selection of the desired depth of scoring by means of a handle 18b or the like.

The lower crossbar 8 is held in position, in the vertical direction, by associated wheels 20 bearing on mobile slides 21, as will be described in detail below.

The carriage 9, 10 bear, coaxially with the respective milling cutters 13, 14, the idle rubber rollers 22, 23 between which the circuit 15 to be scored is gripped during its passage when driven by the conveyor member 2 provided with the relative track 24 connected to the columns 6 which ensures that the circuit passes at the correct height.

A further drive roller 25, keyed on a shaft 26 and provided with a relative pinion 27 for connection to a motor member, is supported on the carriage itself in contact with the idle rubber roller 22 of the upper carriage.

The rubber roller 22 can thus be caused to move by this roller 25 and can in turn exercise traction on the printed circuit brought into contact with it in cooperation with the conveyor group 2, if this is required to ensure a regular passage of the circuit itself; if this help or cooperation is not needed in respect of the dimensions of the printed circuit to be processed, the roller 25 may be idle or even omitted.

In the case that the translation of the printed circuit into the working area is the responsibility of the roller 22 it is also advantageous if the motor of the drive group 2 is connected to the associated chain by a free wheel and has a speed of translation slightly lower than that imparted to the circuit by friction with the roller 22 so that there is no interference with the drive movement itself.

The carriages 9, 10 are connected to the corresponding tracks 28, 29 of the respective crossbars 7, 8 by means of the grooved rollers 30 and can thus be moved horizontally in translation along the crossbars in a direction transverse to the feed direction of the circuits conveyed by the conveyor member 2.

The lower carriage 10 is provided with a nut 31 in which a screw 32 is engaged, which screw can rotate and is axially locked on the crossbar and is provided with an actuation handle 33.

By means of this screw-nut unit 31-32 the carriage 10 can be moved horizontally in translation with precision along the crossbar to the desired working position.

The upper carriage 9 is coupled to the lower carriage 10 by means of a block 34 rigid with the carriage 9 provided with a V-shaped recess within which can be inserted a corresponding tapered bolt 35 of the lower carriage 10 which can slide vertically into the engaged position in the recess of the block 34 by means of an associated actuator 36: in this way the upper carriage can be moved in translation rigidly with the lower carriage by means of the screw 32 and the connection between the carriages can thus be removed, after the desired position has been set, to allow the free passage of the circuits between the two carriages even if they are of large size.

An actuator 37 locks the upper carriage by friction, tightening on its tracks 28 before the disengagement of the tooth 35 from the recess of the block 34 is carried out, thereby preventing undesired movements of the upper carriage.

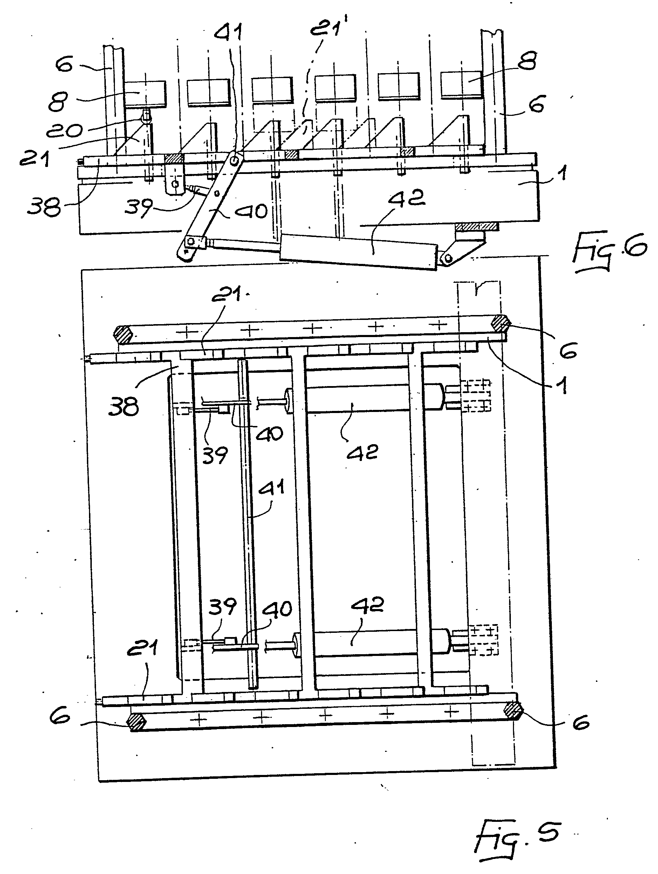

As shown in Figs. 5 and 6, the lower crossbar 8 bears via its respective wheels 20 on the slides 21, a pair of which is provided for each milling unit, borne by a relative frame 38 which can slide horizontally on the frame 1 near the base of the columns 6.

The frame 38 is connected via a pair of crank-rods 39 and levers 40, oscillating about the bar 41 fixed to the frame 1, to a pair of actuators 42 whose ends are also connected to the frame 1.

The vertical movement of each lower crossbar 8 is guided by a pair of associated guide rods 43, one of which is shown in Fig. 4.

In this way, when the actuators 42 are in the extended position, the slides 21 are in the forward position, shown in continuous lines in Fig. 6, and the wheels 20 which can slide above them keep the associated crossbar in the position raised to the predetermined working height; the rearward movement of the frame 38, caused by the actuators 42, into the position 21', shown in Fig. 6 in dot-dash lines, causes the lower crossbars 8 to be lowered, moving them away from the upper crossbar and thus allowing access to the carriages 9, 10 so that maintenance operations such as replacing the milling cutters 13, 14 and the like can be carried out thereon.

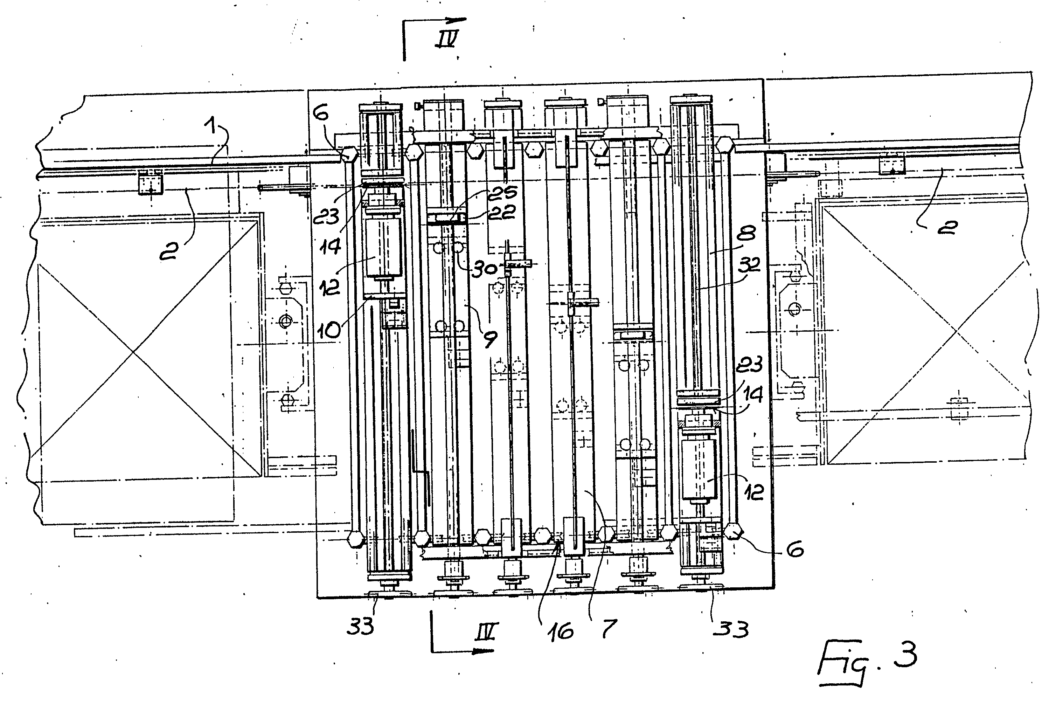

The structure of the invention thus makes it possible, as can be clearly seen from Fig. 3, to carry out milling and parallel incisions on the surfaces of plans sheets such as printed circuits in any position, at distances which do not depend on the size of the individual tools: these incisions are made with tools disposed in successive rows during the movement of the sheet, thereby preventing interference between tools designed to carry out machining on adjacent lines.

Many variants can be made without departing from the general characteristic features of the invention.

## Claims

1. A machine for machining close parallel score lines on plane sheets, characterized in that it comprises a horizontal member for conveying the sheets being processed between a loading area and an unloading area for these sheets and several adjacent groups of milling cutters disposed in succession in the feed direction of the sheet, each bearing an independent milling unit which can be located in the direction traverse to the feed direction of the sheet, means being provided for adjusting the position of each milling unit in the transverse direction and its machining depth.

2. A machine for machining close parallel score lines on plane sheets as claimed in claim 1, characterized in that each milling group comprises an upper crossbar and a lower crossbar connected slidably in the vertical direction between two pairs of vertical columns rigid with the frame of the machine, respectively bearing an upper carriage and a lower carriage which can slide horizontally along the crossbar, each carriage being provided with a milling tool with a respective motor drive member facing the corresponding tool on the opposite carriage at the level of passage of the sheets being conveyed by the conveyor, further support and guide rollers for the sheets being provided on the carriages.

3. A machine for machining close parallel score lines on plane sheets as claimed in claim 1, characterized in that the lower carriage is provided with screw means for adjusting its position along the crossbar and means for connection to the upper carriage.

4. A machine for machining close parallel score lines on plane sheets as claimed in claim 3, characterized in that the screw means for adjusting the position of the lower carriage are formed by a screw borne by the lower crossbar and connected axially thereto engaged in a nut connected rigidly to the lower carriage.

5. A machine for machining close parallel score lines on plane sheets as claimed in claim 3, characterized in that the means for connecting the lower carriage to the upper carriage are formed by a wedge-shaped tapered bolt borne by one of the carriages which can be moved towards the opposite carriage by means of an associated actuator, in correspondence with which there is provided on the opposite carriage a recessed block designed to receive the bolt when it is in the extended position, thus coupling the carriages in translation.

6. A machine for machining close parallel score lines on plane sheets as claimed in claim 2, characterized in that for each pair of facing upper and lower carriages at least one of the support and guide rollers for the sheets is motor driven in order to entrain the sheets.

7. A machine for machining close parallel score lines on plane sheets as claimed in claim 6, characterized in that the motor-driven support roller is actuated at a speed which is slightly higher than that of the sheet conveyor member and the conveyor member is connected to the relative motor means via a free wheel designed to allow the sheets to be entrained by the support and guide rollers when they are in engagement therewith.

8. A machine for machining close parallel score lines on plane sheets as claimed in claim 2, characterized in that the support and guide rollers for the upper and lower carriages are idle and the entrainment of the sheets is carried out solely by the conveyor member.

9. A machine for machining close parallel score lines on plane sheets as claimed in claims 1 and 2, characterzed in that the means for adjusting the depth of machining are formed, for each of the upper crossbars, by a pair of brackets projecting at the ends of the crossbars and provided with associated inclined slides bearing on corresponding wedge-shaped means which can slide longitudinally on guides rigid with the columns sliding longitudinally with fine adjustment of position, thereby determining the height of the crossbar bearing thereon.

10. A machine for machining close parallel score lines on plane sheets as claimed in one or more of the preceding claims, characterized in that the lower crossbars of each milling group are provided with cam means for raising and lowering them between a working position with the tool borne by the associated carriage at the predetermined working height on the sheet and a lowered position allowing access to and maintenance of the tools.

Fig.1

Fig.2

Fig. 3

Fig. 4

EP 0 316 039 A2

Fig. 6

Fig. 5